(19) Europäisches Patentamt
European Patent Office
Office européen des brevets

(11) **EP 1 570 105 B1**

(12) **EUROPÄISCHE PATENTSCHRIFT**

(45) Veröffentlichungstag und Bekanntmachung des Hinweises auf die Patenterteilung:
**21.06.2006 Patentblatt 2006/25**

(51) Int Cl.:
*C23C 16/38* (2006.01)     *C23C 16/36* (2006.01)
*C23C 16/34* (2006.01)     *C23C 16/30* (2006.01)
*B23B 27/14* (2006.01)     *C23C 30/00* (2006.01)
*C23C 28/04* (2006.01)

(21) Anmeldenummer: 03775393.6

(22) Anmeldetag: **26.11.2003**

(86) Internationale Anmeldenummer:
**PCT/EP2003/013289**

(87) Internationale Veröffentlichungsnummer:
**WO 2004/055235 (01.07.2004 Gazette 2004/27)**

(54) **CVD-BESCHICHTUNGSVERFAHREN FÜR ZRBxCyNz-SCHICHTEN (x+y+z=1) SOWIE BESCHICHTETES SCHNEIDWERKZEUG**

METHOD FOR CHEMICAL VAPOUR DEPOSITION (CVD) OF ZRB SB X /SB C SB Y /SB N SB Z /SB (OR X+Y+Z=1) LAYERS AND A CUTTING TOOL COATED WITH SAID LAYER

PROCEDE DE DEPOT CHIMIQUE EN PHASE VAPEUR (CVD) DE COUCHES DE ZRB SB X /SB C SB Y /SB N SB Z /SB (OU X+Y+Z=1), ET OUTIL DE COUPE RECOUVERT D'UNE TELLE COUCHE

(84) Benannte Vertragsstaaten:
**AT BE BG CH CY CZ DE DK EE ES FI FR GB GR HU IE IT LI LU MC NL PT RO SE SI SK TR**

(30) Priorität: **13.12.2002 DE 10258282**

(43) Veröffentlichungstag der Anmeldung:
**07.09.2005 Patentblatt 2005/36**

(73) Patentinhaber: **WALTER AG**
**72072 Tübingen (DE)**

(72) Erfinder: **HOLZSCHUH, Helga**
**72537 Mehrstetten (DE)**

(74) Vertreter: **Rüger, Barthelt & Abel**
**Patentanwälte**
**Webergasse 3**
**73728 Esslingen (DE)**

(56) Entgegenhaltungen:
WO-A- 00/14300         DE-U- 29 818 029
US-A- 4 239 536        US-A- 4 629 661
US-A- 4 895 770

• RANDICH E ET AL: "CHEMICALLY VAPOR-DEPOSITED ZRB2 AS A SELECTIVE SOLAR ABSORBER" THIN SOLID FILMS, ELSEVIER-SEQUOIA S.A. LAUSANNE, CH, Bd. 83, Nr. 19, 6. April 1981 (1981-04-06), Seiten 393-398, XP001079794 ISSN: 0040-6090
• PATENT ABSTRACTS OF JAPAN vol. 1998, no. 11, 30. September 1998 (1998-09-30) -& JP 10 176289 A (BALZERS AG;HITACHI TOOL ENG LTD), 30. Juni 1998 (1998-06-30)

## Beschreibung

Die Erfindung betrifft ein CVD-Beschichtungsverfahren zur Erzeugung einer Hartstoffschicht, die Zirkonium, Stickstoff und/oder Kohlenstoff und Bor enthält.

$ZrB_xC_yN_z$-Schichten, beispielsweise auf Wolframcarbid-Körpern, sind aus dem Stand der Technik bekannt. Die Benutzung von PVD oder PACVD wie es zur Herstellung von ZrBCN-Schichten benutzt wird, wird jedoch häufig abgelehnt.

Aus der US-PS 6146697 ist ein CVD-Verfahren zur Erzeugung von $ZrB_xC_yN_z$-Schichten mit y, z > 0 auf Substraten, wie beispielsweise Wolfram-Carbid bekannt. Es handelt sich hier um ein Mitteltemperaturverfahren (MT-CVD) das in einem Temperaturbereich von 700°C bis 900°C arbeitet. Dieses Verfahren dient zur Herstellung von Borcarbonitriden von Titan und soll sich auch zur Herstellung von Borcarbonitriden von Hafnium, Niob, Vanadium, Zirkonium oder Tantal eignen. Der CVD-Prozess läuft bei einer mittleren Temperatur (z.B. zwischen 550°C und 900°C) unter einem Druck von 5 bis 800 Torr ab. Als Prozessgas dient ein Gemisch aus einem Kohlenstoff/Stickstoff-Precursor, z.B. $CH_3CN$, Borchlorid oder einem anderen Borhalogenid, Titanchlorid, Stickstoff und Wasserstoff. Der Prozess wird in einem Reaktionsraum durchgeführt, in dem die Prozessgase alle Substrate nacheinander (seriell) überstreichen. Zur Vergleichmäßigung der Abscheidungsreaktion und zur Vergrößerung der Abscheidungsrate enthält die Prozessatmosphäre große Mengen (1 % bis 30 %) Chlorwasserstoff (HCl). Dies ergibt Titanborcarbonitridschichten. Es wird angegeben, dass anstelle von Titanchlorid ein Zirkoniumhalogenid verwendet werden kann, so dass eine Zirkoniumborcarbonitridschicht entsteht. Der $TiCl_4$-Gehalt der Prozessatmosphäre liegt bei allen Ausführungsbeispielen zwischen 0,9 Volt und 2,1 Vol%. Durch die Verwendung von Acetonitril oder anderen stickstoffhaltigen Kohlenwasserstoffverbindungen ist das C/N-Verhältnis festgelegt.

Aus der JP 55008485 A ist es bekannt, auf technischen Elementen eine Zirkonbornitridschicht abzuscheiden. Diese wird erzeugt, indem ein Hartmetallelement im CVD-Verfahren, einer Atmosphäre ausgesetzt wird, die Zirkontetrachlorid sowie Wasserstoff, Stickstoff, Methan und Bortrichlorid enthält.

Borcarbonitridschichten können auf diese Weise nicht erzeugt werden.

Aus der WO-A-00/14300 ist ein Schneidwerkzeug mit einer Hartstoffbeschichtung bekannt, die in einem PVD-Prozess hergestellt worden ist. Die Beschichtung weist folgende Zusammensetzung auf: $ZrB_{0.1}C_{0.1}N_{0.8}$. Außerdem kann die Schicht als $ZrB_{0.1}N_{0.9}$ oder $ZrB_{0.4}N_{0.6}$-Schicht aufgebaut sein.

Es ist Aufgabe der Erfindung, ein abweichendes Verfahren zur Erzeugung von Zirkoniumborcarbonitridschichten anzugeben. Außerdem ist es Aufgabe der Erfindung, ein Verfahren anzugeben, mit dem sich glatte, metallisch glänzende und verschleißfeste Zirkoniumborcarbonitridschichten erzeugen lassen.

Bei dem erfindungsgemäßen CVD-Beschichtungsverfahren wird mit einer Gasatmosphäre aufgebaut, deren Gaszufluss durch ein wasserstoffhalogenidfreies Gasgemisch gebildet wird. Zu den Prozessgasen gehören ein Zirkoniumhalogenid mit einem Anteil von 5 Vol% bis 12 Vol%. Außerdem ist ein Borhalogenid von 0,02 Vol% bis 5 Vol%, ein Kohlenstoff/Stickstoff-Precursor von 0 Vol% bis 5 Vol%, Stickstoff von 0 Vol% bis 20 Vol% und ein inaktiver Rest, z.B. in Form von molekularem Wasserstoff $H_2$ enthalten. Durch den hohen Zirkoniumhalogenidgehalt von bis 12 Vol% wird eine wirtschaftliche Abscheidungsgeschwindigkeit erreicht, die den Aufbau ausreichend dicker und gleichmäßiger ZrBCN-Schichten ermöglicht. Dabei wird vorzugsweise bei relativ geringen Abscheidedz-ücken zwischen beispielsweise 40 und 150 mbar gearbeitet, was hohe Abscheidegeschwindigkeiten begünstigt. Der Borgehalt der Prozessatmosphäre wird vorzugsweise so gering eingestellt, dass sich in der Hartstoffschicht eine kubische ZrCN-Matrix ausbildet, in die Bor eingelagert ist, ohne dass sich $ZrB_2$-Kristalle bilden. Mit den genannten Gasflüssen und sonstigen Prozesspärametern lässt sich dies erreichen. Es ergeben sich ohne HCl-Zusatz zu dem Prozessgas trotzdem sehr gleichmäßige Schichten. In der Prozessatmosphäre bildet sich durch die Abscheidungsreaktion HCl.

Das als Prozessgas in den Reaktionsraum eingeführte Zirkoniumhalogenid ist vorzugsweise Zirkoniumchlorid. Ersatzweise kann jedoch auch Zirkoniumfluorid, Zirkoniumjodid oder Zirkoniumbromid sowie eine beliebige Mischung aus den genannten Halogeniden zur Anwendung kommen.

Als Borhalogenid wird Borchlorid bevorzugt. Andere Borhalogenide oder Mischungen aus diesen sind möglich. Im Übrigen wird bevorzugt, sowohl Zirkoniumhalogenid als auch das Borhalogenid von dem gleichen Halogen abzuleiten. Es ist jedoch auch möglich, beispielsweise Zirkoniumchlorid mit Borbromid zu mischen.

Als Kohlenstoffträger kann Methan vorgesehen werden. Als gemischter Kohlenstoff/Stickstoff-Träger kann als Precursor $CH_3CN$, $CH_3NH_2$, $(CH_3)_2NR$, $(CH_3)_3N$, $HCN$, $CH_3(NH)_2CH_3$ verwendet werden. In letzterem Fall kann die Prozessatmosphäre zusätzlich molekularen Stickstoff enthalten, muss es aber nicht.

Mit dem erfindungsgemäßen Beschichtungsverfahren lässt sich jedes geeignete Substrat beschichten. Es ist mit einem sonstigen CVD-Prozess kompatibel. Es kann zur Beschichtung von Keramik, carbidischen Hartstoffen, Cermets, Hochgeschwindigkeitsstählen und anderen Stählen sowie Siliziumnitrid ($Si_3N_4$) verwendet werden. Außerdem kann das Beschichtungsverfahren zur Aufbringung einer ZrBCN-Schicht auf TiN, TiCN, TiC, ZrCN, ZrC, ZrN, FlfCN, HfC, HfN etc. sowie Aluminiumoxid ($Al_2O_3$) oder einer anderen Schicht angewendet werden. Gegebenenfalls können Bindungsschichten Anwendung finden, jedoch ist die Haftung auf den Nitriden, Carbiden, Carbonitriden von Ti, Zr, Hf und auf Aluminiumoxid jeweils gut. Außerdem lassen sich auf der ZrBCN-Schicht weitere Schichten abscheiden. Die Schichten erweisen sich als hart und verschleißfest. $ZrB_xC_yN_z$ erreicht bei x = 0.01 Härten von 3.000 HV, während eine reine ZrCN-Schicht ohne Bor (x = 0) lediglich eine Härte von 2.500 HV erreicht.

Außerdem lassen sich die ZrBCN-Schichten als dekorative Deckschichten verwenden. ZrBCN abgeschieden mit den Precursoren $CH_3CN$, $ZrCl_4$, $BCl_3$, ergibt einen metallisch glänzenden Lilaton. Mit den Precursoren bzw. Gasanteilen CH4 und N2 lässt sich der Farbton von Gelb bis zu Grau einstellen. ZrBN-Schichten geben einen hellen Champagnerton mit Metallglanz. ZrBC-Schichten erscheinen metallisch grau glänzend.

$ZrB_xC_yN_z$ eignet sich besonders zur Beschichtung von Schneidwerkzeugen. Beispielsweise wurden unterschiedliche Verschleißdeckschichten im Frästest untersucht. Das beste Verschleißverhalten zeigen ZrBCN-Schichten. Beispielsweise ist eine ZrBCN-Schicht beim Vergleich des Freiflächenverschleißes eines Schneidwerkzeuges weitaus verschleißfester als TiCN, das wiederum verschleißfester als ZrCN ist. Letzteres ist wiederum TiBCN weit überlegen. Für den Verschleiß gilt somit: TiBCN » ZrCN > TiCN > ZrBCN.

Weitere Einzelheiten vorteilhafter Details von Ausführungsformen der Erfindung ergeben sich aus Unteransprüchen oder der nachfolgenden Beschreibung.

In der $ZrB_xC_yN_z$-Schicht (x+y+z = 1, x ≠ 0) können Teile des Zirkoniums durch Titan und/oder Hafnium ersetzt sein. Dazu werden dem Prozessgas zusätzlich zu dem Zirkoniumhalogenid oder unter Ersatz von Bruchteilen desselben Halogenide von Titan oder Hafnium beigegeben. Vorzugsweise beruhen diese Halogenide auf dem gleichen Halogen wie das Zirkoniumhalogenid. Es wird auch in Betracht gezogen, das Zirkoniumhalogenid durch ein Chlorid, Fluorid, Bromid oder Jodid des Niob, Vanadium oder Tantal zu ergänzen und/oder teilweise zu ersetzen. Bordotiertes Zirkoniumcarbonitrid ($ZrB_xC_yN_z$) weist ein kubisches Gitter auf. Vanadium, Niob oder Tantal kann allerdings zu anderen Gitterstrukturen führen, wenn es Zirkonium ganz oder teilweise ersetzt. Die Prozessatmosphäre ist außerdem vorzugsweise frei von Kohlenmonoxid oder Kohlendioxid. Es werden außerdem keine Wasserstoffhalogenide, insbesondere kein HCl in den Reaktionsraum eingeleitet. Jedoch kann HCl in dem CVD-Prozess entstehen.

Die gemäß den nachfolgend beschriebenen Ausführungsbeispielen erzeugten ZrBCN-Schichten unterscheiden sich von herkömmlichen ZrCN-Schichten durch eine Erhöhung der Härte, eine metallisch glänzende Farbe und eine Verfeinerung der Kristallstruktur. Deshalb wird angenommen, dass das Bor in einem kubischen ZrCN-Gitter vorliegt. XRD- und TEM-Analysen bestätigen, dass sich kein $ZrB_2$ bildet, d.h. dass die $ZrB_xC_yN_z$-Schicht weitgehend $ZrB_2$-frei ist. Das kubische ZrCN-Gitter kann deshalb als mit Bor dotiert angesehen werden. In der Summenformel $Zr(B_xC_yN_z)$ mit x+y+z = 1 liegt der Borgehalt zwischen 0,001 und 0,05, bevorzugterweise zwischen 0,005 und 0,02. Durch die Bordotierung wird durch Verfeinerung der Kristallstruktur eine sehr gleichmäßige und glatte Oberfläche erreicht. Dies reduziert den Verschleiß auch aufgrund der Glättung der Oberfläche gegenüber von ZrC-, ZrN- oder ZrCN-Schichten ohne Bor. Die Schichten eignen sich insbesondere als Verschleißschutzschichten zur Beschichtung von Werkzeugen zur Stahlzerspanung. Die guten Verschleißeigenschaften dieser Schichten werden auf die hohe Härte von bis zu 3.000 HV, die glatte Oberfläche und die guten Reibeigenschaften zurückgeführt.

Die Herstellung erfolgt im CVD-Verfahren bei einer Abscheidetemperatur zwischen 900°C und 1.100°C. Es werden homogene Schichten erhalten, die fest auf dem jeweiligen Träger haften. Die Kristallstruktur ist sehr fein. Durch Zugabe von Titan oder Hafnium-Verbindungen zu der Prozessatmosphäre können (Zr,Ti) (BCN)-Schichten - (Zr, Hf) (BCN) -Schichten oder (Zr, Ti, HF) (BCN)-Schichten erzielt werden, die kubische Struktur haben und hart und verschleißfest sind.

Alle nachfolgenden Beispiele ausgeführter CVD-Beschichtungen sind in einem Reaktor ausgeführt worden, der mehrere Tabletts mit zu beschichtenden Gegenständen, beispielsweise Schneidplatten aus Wolframcarbid, aufweist. Die Reaktionsgase werden parallel über alle Tabletts verteilt. Dazu ist ein zentrales Rohr vorgesehen, das alle Tabletts vertikal durchsetzt und dessen Mantel Ausströmöffnungen zur parallelen Begasung jedes Tabletts aufweist.

Beispiel 1:

Herstellung einer 5 μm dicken $ZrB_xC_yN_z$-Schicht auf TiN von 0,5 μm:

Mitteltemperaturverfahren, Herstellung von 5 μm MT-ZrBCN auf einem Träger, z.B. einer Schneidplatte mit TiN-Schicht gemäß nachfolgender Tabelle:

|  | MT-ZrBCN |
| --- | --- |
| Farbe | metallisch Lila |
| Dauer | 6 Stunden |
| Prozessdruck | 100 mbar |

Tabelle fortgesetzt

|  | MT-ZrBCN |
|---|---|
| Abscheidetemperatur | 950°C |
| $ZrCl_4$ | 5 Vol% |
| $CH_3CN$ | 3 Vol% |
| $N_2$ | 15 Vol% |
| $BCl_3$ | 0,1 Vol% |
| $H_2$ | Balance |

Die so erhaltene metallisch Lila glänzende Schicht eignet sich aufgrund ihrer Eigenschaften insbesondere als Dekorschicht sowie als Deckschicht bei der Stahlzerspanung.

Beispiel 2:

Es wird eine Schneidplatte mit folgender Schichtfolge hergestellt, wobei die erstgenannte Schicht die Grundschicht und die letztgenannte Schicht die außenliegende Dekorschicht ist:

TiN: 0,5 $\mu$m
MT-TiCN: 8 $\mu$m
Bindungsschicht z.B. TiAlCNO: 0,8 $\mu$m
$Al_2O_3$: 6 $\mu$m
Zr-B-C-N : 2 $\mu$m

Alle genannten Schichten können im CVD-Verfahren in ein und demselben Reaktionsraum hergestellt werden. Die Herstellung der letzten Schicht kann mit folgenden Prozessparametern erfolgen:

|  | ZrBCN |
|---|---|
| Farbe | metallisch Lila |
| Dauer | 180 min |
| Prozessdruck | 90 mbar |
| Abscheidetemperatur | 950°C |
| $ZrCl_4$ | 6 Vol% |
| $CH_3CN$ | 1 Vol % |
| $BCl_3$ | 0,05 Vol% |
| $H_2$ | Balance |

Bei allen vorgenannten Beispielen kann das Zirkoniumtetrachlorid durch ein anderes Halogenid ersetzt werden. Außerdem kann es zumindest teilweise durch ein Titanhalogenid, Hafniumhalogenid oder ein anderes Halogenid, wie Vanadiumhalogenid, Niobhalogenid oder Tantalhalogenid ersetzt sein. Dadurch lassen sich auch Mischphasen (Zr,Ti) (BCN), (Zr,Hf)(BCN) oder (Zr,Ti,Hf)(BCN) erhalten. Diesen ist gemeinsam, dass ein Gitter vorliegt, in das Bor wie eine Dotierung eingebaut ist, ohne dass eine zweite Phase als Boridverbindung vorliegt. Zumindest wenn der Zirkoniumanteil überwiegt, liegt ein kubisches Gitter vor. Die einphasige kubische Struktur unterscheidet die im CVD-Verfahren hergestellten Schichten von Schichten, die im PVD-Verfahren oder anderen Verfahren erzeugt worden sind.

Zur Herstellung einer $Zr(B_xC_yN_z)$-Schicht mit x+y+z = 1 und x: 0,001 bis 0,05, y von größer als 0 bis 0,95 und z von größer als 0 bis 0,95 im CVD-Verfahren wird ein Prozessgas verwendet, das über 5 Vol% Zr-Halogenid und weniger als 5 Vol% Borhalogenid enthält. Dem Prozessgas wird jedoch kein bremsend wirkendes Wasserstoffhalogenid zugesetzt. Die entstehenden Schichten eignen sich als Verschleißschutz oder als Dekorschicht.

Alle vorstehend diskutierten-$ZrB_xC_yN_z$-Schichten können auf oder unter einer $Al_2O_3$-Schicht oder alternativ auf oder unter einer $ZrO_2$-Schicht vorgesehen werden. Zur Verbesserung der Haftung zwischen den genannten Zirkoniumborcarbonitridschichten und einer Aluminiumoxidschicht oder einer Zirkoniumoxidschicht können haftungsverbessernde Zwischenschichten vorgesehen sein. Hierzu eignen sich insbesondere Titanaluminiumcarbonitridoxidschichten (TiAlCNO), Zirkoniumcarbonitridoxidschichten (ZrCNO) oder Zirkoniumaluminiumcarbonitridoxidschichten (ZrAlCNO). Die aluminiumhaltigen Zwischenschichten enthalten Aluminium, das Kristallisationskeime und somit Verankerungspunkte für eine aufzubringende $Al_2O_3$-Schicht enthält. Die ZrCNO-Schicht wird insbesondere zur Haftungsverbesserung einer $ZrO_2$-Schicht vorgeschlagen. Die TiAlCNO-Schichten und die ZrAlCNO-Schichten liegen vorzugsweise in einer Pseudobrookitstruktur vor. Diese enthält $Al_2TiO_5$ bzw. $Al_2zrO_5$ sowie Titancarbonitrid ($TiC_xN_y$) bzw. Zirkoncarbonitrid ($ZrC_xN_y$). $Al_2TiO_5$ und die TiCN liegen als makroskopische Kristalle nebeneinander vor. Ebenso liegen $Al_2ZrO_5$ und ZrCN als makroskopische Kristalle nebeneinander vor. Die Bindungsschicht besteht somit aus Titancarbonitrid bzw. Zirkoncarbonitrid mit kubischem Gitter und Stickstoff auf einem Drittel aller Kohlenstoffplätze. Dieses Gitter ist sauerstofffrei. Der Sauerstoff ist vollständig von Aluminiumtitanatkristallen bzw. Aluminiumzirkonatkristallen gebunden.

**Patentansprüche**

1.  CVD-Beschichtungsverfahren zur Erzeugung einer Zr ($B_xC_yN_z$) -Schicht mit:

$$x + y + z = 1,$$

$$0,001 \leq x \leq 0,05,$$

$$0 < y \leq 0,95$$

und

$$0 < z \leq 0,95,$$

bei dem mit dieser Schicht zu beschichtende Substrate in einem Reaktionsraum einer Gas-Atmosphäre ausgesetzt werden, die durch einen Wasserstoff-Halogenidfreien Gasfluss folgender Zusammensetzung aufgebaut wird:

| | |
|---|---|
| Zirkoniumhalogenid | 3 bis 15 Vol %, |
| Borhalogenid | 0,02 bis 5 Vol %, |
| Kohlenstoffträger | 0 bis 5 Vol %, |
| Stickstoff | 0 bis 20 Vol %, |
| inaktiver Rest | als Ergänzung zu 100 Vol %, |

wobei in dem Reaktionsraum eine Temperatur zwischen 900°C und 1100°C
und ein Druck von 50 mbar bis 950 mbar eingehalten wird.

2.  CVD-Beschichtungsverfahren nach Anspruch 1, **dadurch gekennzeichnet, dass** das Zirkoniumhalogenid Zirkoniumchlorid ist.

3.  CVD-Beschichtungsverfahren nach Anspruch 1, **dadurch gekennzeichnet, dass** das Zirkoniumhalogenid Zirkoniumfluorid ist.

4.  CVD-Beschichtungsverfahren nach Anspruch 1, **dadurch gekennzeichnet, dass** das Zirkoniumhalogenid Zirkoniumjodid ist.

5.  CVD-Beschichtungsverfahren nach Anspruch 1, **dadurch gekennzeichnet, dass** das Zirkoniumhalogenid Zirkoniumbromid ist.

6.  CVD-Beschichtungsverfahren nach Anspruch 1, **dadurch gekennzeichnet, dass** das Borhalogenid Borchlorid ist.

7. CVD-Beschichtungsverfahren nach Anspruch 1, **dadurch gekennzeichnet, dass** der Kohlenstoffträger ein aus folgender Gruppe ausgewähltes Gas oder Gasgemisch ist: $CH_4$, $CH_3CN$, $CH_3NH_2$, $(CH_3)_2NH$, $(CH_3)_3N$, HCN, $CH_3(NH)_2CH_3$.

8. CVD-Beschichtungsverfahren nach Anspruch 1, **dadurch gekennzeichnet, dass** der Stickstoffträger ein aus folgender Gruppe ausgewähltes Gas oder Gasgemisch ist: $CH_3CN$, $CH_3NH_2$, $(CH_3)_2NH$, $(CH_3)_3N$, HCN, $CH_3(NH)_2CH_3$, $N_2$, $NH_3$.

9. CVD-Beschichtungsverfahren nach Anspruch 1, **dadurch gekennzeichnet, dass** der inaktive Rest Wasserstoff ist.

10. CVD-Beschichtungsverfahren nach Anspruch 1, **dadurch gekennzeichnet, dass** die Temperatur zwischen 950°C und 1050°C liegt.

11. CVD-Beschichtungsverfahren nach Anspruch 1, **dadurch gekennzeichnet, dass** ein geringerer Anteil des Zirkoniumhalogenids durch ein Halogenid eines oder mehrerer Metalle aus der Gruppe Titan und Hafnium ersetzt ist.

12. Schneidwerkzeug mit einer im CVD-Verfahren nach Anspruch 1 hergestellten Hartstoffschicht folgender Zusammensetzung:

$$Zr(B_xC_yN_z)$$

mit :

$$x + y + z = 1$$

und

$$0,001 \leq x \leq 0,05,$$

$$0 < y \leq 0,95,$$

$$0 < z \leq 0,95.$$

13. Schneidwerkzeug nach Anspruch 12, **dadurch gekennzeichnet, dass** die $Zr(B_xC_yN_z)$-Schicht $Zr(C_yN_z)$ in kubischer Phase enthält, in die Bor eingelagert ist.

14. Schneidwerkzeug nach Anspruch 12, **dadurch gekennzeichnet, dass** die $Zr(B_xC_yN_z)$-Schicht frei von $ZrB_2$-Kristalliten ist.

15. Schneidwerkzeug ,nach Anspruch 12, **dadurch gekennzeichnet, dass** die $Zr(B_xC_yN_z)$-Schicht mit einer $Al_2O_3$-Schicht oder mit einer $ZrO_2$-Schicht kombiniert ist.

16. Schneidwerkzeug nach Anspruch 18, **dadurch gekennzeichnet, dass** jeweils zumindest eine Zwischenschicht aus TiAlCNO, ZrCNO und/oder ZrAlCNO vorgesehen ist.

17. Schneidwerkzeug nach Anspruch 12, **dadurch gekennzeichnet, dass** die $ZrB_xC_yN_z$-Schicht mit weiteren Schichten kombiniert ist, die Titan, Zirkonium, Hafnium, Vanadium und/oder Tantal oder ein sonstiges Element der Gruppe IVa und Va in Form von Carbiden, Nitriden, Carbonitriden und/oder Carbooxonitriden oder Mischungen aus diesen enthalten.

**Claims**

1.  CVD coating process for the generation of a $Zr(B_xC_yN_z)$ layer where:

$$x + y + z = 1,$$

$$0.001 \leq x \leq 0.05,$$

$$0 < y \leq 0.95$$

and

$$0 < z \leq 0.95,$$

wherein with this layer substrates to be coated are subjected to a gas atmosphere in a reaction chamber composed of a hydrogen halide-free gas flow of the following composition:

| | |
|---|---|
| zirconium halide | 3 to 15 % vol., |
| boron halide | 0.02 to 5 % vol., |
| carbon carrier | 0 to 5 % vol., |
| nitrogen | 0 to 20 % vol., |
| inactive residue | balance to 100 % vol. |

wherein a temperature between 900°C and 1100°C
and a pressure of 50 mbar to 950 mbar are maintained in the reaction chamber.

2.  CVD coating process according to Claim 1, **characterised in that** the zirconium halide is zirconium chloride.

3.  CVD coating process according to Claim 1, **characterised in that** the zirconium halide is zirconium fluoride.

4.  CVD coating process according to Claim 1, **characterised in that** the zirconium halide is zirconium iodide.

5.  CVD coating process according to Claim 1, **characterised in that** the zirconium halide is zirconium bromide.

6.  CVD coating process according to Claim 1, **characterised in that** the boron halide is boron chloride.

7.  CVD coating process according to Claim 1, **characterised in that** the carbon carrier is a gas or gas mixture selected from the following group: $CH_4$, $CH_3CN$, $CH_3NH_2$, $(CH_3)_2NH$, $(CH_3)_3N$, $HCN$, $CH_3(NH)_2CH_3$.

8.  CVD coating process according to Claim 1, **characterised in that** the nitrogen carrier is a gas or gas mixture selected from the following group: $CH_3CN$, $CH_3NH_2$, $(CH_3)_2NH$, $(CH_3)_3N$, $HCN$, $CH_3(NH)_2CH_3$, $N_2$, $NH_3$.

9.  CVD coating process according to Claim 1, **characterised in that** the inactive residue is hydrogen.

10. CVD coating process according to Claim 1, **characterised in that** the temperature lies between 950°C and 1050°C.

11. CVD coating process according to Claim 1, **characterised in that** a smaller proportion of zirconium halide is substituted by a halide of one of more metals from the group titanium and hafnium.

12. Cutting tool with a hard material layer produced using the CVD process according to Claim 1 having the following composition:

$$Zr(B_xC_yN_z)$$

where:

$$x + y + z = 1,$$

and

$$0.001 \leq x \leq 0.05,$$

$$0 < y \leq 0.95$$

$$0 < z \leq 0.95.$$

**13.** Cutting tool according to Claim 12, **characterised in that** the $Zr(B_xC_yN_z)$ layer contains $Zr(C_yN_z)$ in cubic phase, into which boron is incorporated.

**14.** Cutting tool according to Claim 12, **characterised in that** the $Zr(B_xC_yN_z)$ layer is free from $ZrB_2$ crystallites.

**15.** Cutting tool according to Claim 12, **characterised in that** the $Zr(B_xC_yN_z)$ layer is combined with an $Al_2O_3$ layer or with a $ZrO_2$ layer.

**16.** Cutting tool according to Claim 18[?], **characterised in that** at least one respective intermediate layer of TiAICNO, ZrCNO and/or ZrAICNO is provided.

**17.** Cutting tool according to Claim 12, **characterised in that** the $ZrB_xC_yN_z$ layer is combined with further layers, which contain titanium, zirconium, hafnium, vanadium and/or tantalum or another element from group IVa and Va in the form of carbides, nitrides, carbonitrides and/or carbo-oxonitrides or mixtures from these.

**Revendications**

**1.** Procédé de revêtement par CVD (dépôt chimique à partir d'une phase vapeur) pour la production d'une couche de $Zr(B_xC_yN_z)$,
où

$$x + y + z = 1$$

$$0,001 \leq x \leq 0,05$$

$$0 \leq y \leq 0,95$$

et

$$0 \leq z \leq 0,95$$

dans lequel on place dans une enceinte de réaction des substrats que l'on veut revêtir d'une telle couche et on les y expose à l'action d'une atmosphère gazeuse formée par un courant gazeux exempt d'halogénure d'hydrogène, dont la composition est la suivante :

| | |
|---|---|
| halogénure de zirconium | 3 à 15 % en volume |
| halogénure de bore | 0,02 à 5 % en volume |
| vecteur de carbone | 0 à 5 % en volume |
| azote | 0 à 20 % en volume |
| reste inactif | complément à 100 % en volume |

tout en maintenant dans l'enceinte de réaction une température de 900 à 1100 °C et une pression de 50 à 950 mbar.

2. Procédé de revêtement par CVD, conforme à la revendication 1, **caractérisé en ce que** l'halogénure de zirconium est du chlorure de zirconium.

3. Procédé de revêtement par CVD, conforme à la revendication 1, **caractérisé en ce que** l'halogénure de zirconium est du fluorure de zirconium.

4. Procédé de revêtement par CVD, conforme à la revendication 1, **caractérisé en ce que** l'halogénure de zirconium est du iodure de zirconium.

5. Procédé de revêtement par CVD, conforme à la revendication 1, **caractérisé en ce que** l'halogénure de zirconium est du bromure de zirconium.

6. Procédé de revêtement par CVD, conforme à la revendication 1, **caractérisé en ce que** l'halogénure de bore est du chlorure de bore.

7. Procédé de revêtement par CVD, conforme à la revendication 1, **caractérisé en ce que** le vecteur de carbone est un gaz ou un mélange de gaz choisi(s) parmi les suivants : $CH_4$, $CH_3CN$, $CH_3NH_2$, $(CH_3)_2NH$, $(CH_3)_3N$, HCN et $CH_3(NH)_2CH_3$.

8. Procédé de revêtement par CVD, conforme à la revendication 1, **caractérisé en ce que** le vecteur d'azote est un gaz ou un mélange de gaz choisi(s) parmi les suivants : $CH_3CN$, $CH_3NH_2$, $(CH_3)_2NH$, $(CH_3)_3N$, HCN, $CH_3(NH)_2CH_3$, $N_2$ et $NH_3$.

9. Procédé de revêtement par CVD, conforme à la revendication 1, **caractérisé en ce que** le reste inactif est de l'hydrogène.

10. Procédé de revêtement par CVD, conforme à la revendication 1, **caractérisé en ce que** la température vaut de 950 à 1450 °C.

11. Procédé de revêtement par CVD, conforme à la revendication 1, **caractérisé en ce qu'**une partie mineure de l'halogénure de zirconium est remplacée par un halogénure d'un ou plusieurs métaux choisis parmi le titane et le hafnium.

12. Outil de coupe muni d'une couche de matériau dur, produite selon un procédé CVD conforme à la revendication 1, dont la composition est la suivante :

$Zr(B_xC_yN_z)$

où

$$x + y + z = 1$$

$$0,001 \leq x \leq 0,05$$

$$0 \leq y \leq 0,95$$

et

$$0 \leq z \leq 0,95.$$

13. Outil de coupe conforme à la revendication 12, **caractérisé en ce que** la couche de $Zr(B_xC_yN_z)$ contient une phase cubique de $Zr(C_yN_z)$ où est inséré du bore.

14. Outil de coupe conforme à la revendication 12, **caractérisé en ce que** la couche de $Zr(B_xC_yN_z)$ ne contient pas de cristallites de $ZrB_2$.

15. Outil de coupe conforme à la revendication 12, **caractérisé en ce que** la couche de $Zr(B_xC_yN_z)$ est combinée avec une couche de $Al_2O_3$ ou avec une couche de $ZrO_2$.

16. Outil de coupe conforme à la revendication 12, **caractérisé en ce qu'**il y a au moins une couche intermédiaire de TiAlCNO, ZrCNO et/ou ZrAlCNO.

17. Outil de coupe conforme à la revendication 12, **caractérisé en ce que** la couche de $Zr(B_xC_yN_z)$ est combinée avec d'autres couches qui contiennent du titane, du zirconium, du hafnium, du vanadium et/ou du tantale ou un autre élément des groupes IVa et Va, à l'état de carbures, de nitrures, de carbonitrures et/ou d'oxycarbonitrures ou de mélanges de tels corps.